**Europäisches Patentamt**

**European Patent Office**

**Office européen des brevets**

(19)

(11) **EP 1 553 697 A1**

(12) **DEMANDE DE BREVET EUROPEEN**

(43) Date de publication:
**13.07.2005 Bulletin 2005/28**

(51) Int Cl.⁷: **H03F 7/00**, H03F 7/04,
G01P 15/09, G01P 15/08

(21) Numéro de dépôt: **04000260.2**

(22) Date de dépôt: **08.01.2004**

(84) Etats contractants désignés:
**AT BE BG CH CY CZ DE DK EE ES FI FR GB GR
HU IE IT LI LU MC NL PT RO SE SI SK TR**
Etats d'extension désignés:
**AL LT LV MK**

(71) Demandeur: **ETA SA Manufacture Horlogère
Suisse
2540 Grenchen (CH)**

(72) Inventeur: **Bisig, Martin
4528 Zuchwil (CH)**

(74) Mandataire: **Vigand, Philippe et al
ICB,
Ingénieurs Conseils en Brevets SA,
Rue des Sors 7
2074 Marin (CH)**

(54) **Dispositif de détection de signaux basses fréquences**

(57)    L'invention concerne un dispositif de détection (10) comprenant un capteur (20) pour mesurer un signal externe, le capteur ayant une fréquence de résonance (Fc), un circuit d'adaptation d'impédance non-linéaire (30 ; 50) pour amplifier le signal mesuré ($X_{in}$) et le décaler à une fréquence supérieure, le circuit d'adaptation d'impédance comprenant au moins un composant électrique (33 ; 51) ayant une valeur variable non-linéairement dans le temps et un circuit de pompage (40) du circuit d'adaptation d'impédance pour faire varier la valeur dudit composant électrique. Le dispositif de détection est caractérisé en ce que ledit circuit de pompage délivre des signaux ($X_p$) pour faire varier non-linéairement la valeur du composant à ladite fréquence de résonance du capteur.

Fig. 2

EP 1 553 697 A1

## Description

### DOMAINE TECHNIQUE

La présente invention concerne, de manière générale, un dispositif de détection de signaux basses fréquences, comme par exemple, un accéléromètre destiné à être intégré dans un objet portable, du type montre-bracelet. L'invention concerne plus particulièrement le circuit d'adaptation d'impédance permettant de décaler la fréquence du signal détecté et d'amplifier l'amplitude de ce même signal. La présente invention concerne également le procédé de mise en oeuvre d'un tel dispositif pour détecter des signaux basses fréquences.

### ARRIÈRE-PLAN TECHNOLOGIQUE

Il est connu dans l'art antérieur, d'utiliser un élément piézoélectrique comme capteur d'accélération. Le capteur d'accélération est connecté à un circuit de détection d'accélération permettant principalement d'amplifier les signaux reçus par le capteur.

Afin de perdre le moins de puissance possible entre le capteur et le circuit de détection d'accélération, ce dernier permet également d'adapter l'impédance des signaux reçus par le capteur. Classiquement, l'adaptation d'impédance est réalisée au moyen d'un circuit LC, dont les valeurs de capacité et/ou d'inductance sont variables, ce qui permet de les ajuster en fonction des signaux externes détectés.

De tels dispositifs présentent cependant certains inconvénients pour la détection de signaux basses fréquences. En effet, à basses fréquences, les signaux reçus par le capteur, par exemple un cristal piézoélectrique, peuvent être à très haute impédance. Dans ce cas, l'impédance de source est généralement équivalente à un circuit RC ou RLC avec une faible valeur de capacité. Pour détecter de tels petits signaux, le bruit ambiant devient alors rapidement un important facteur limitant. Pour améliorer le rapport signal sur bruit, il est nécessaire d'adapter l'impédance de la source, i.e. du capteur, à l'impédance de la charge, i.e. au circuit de détection. Néanmoins, à basse fréquence et haute impédance, cela devient très difficile, en raison des valeurs extrêmes requises pour les composants électriques du circuit de détection. Pour avoir un ordre d'idée, en théorie une inductance de plusieurs henrys peut s'avérer nécessaire.

Pour surmonter le problème de la difficulté d'adaptation des circuits de détection traditionnels, il a été décrit dans un article intitulé « A Novel Parametric-Effect MEMS Amplifier », publié dans le « Journal of Microelectromechanical Systems, vol. 9, No. 4, December 2000 », l'utilisation d'un amplificateur micromécanique à effet paramétrique.

Des amplificateurs à effet paramétrique basés sur des réactances non-linéaires comme des capacités ou des inductances ont été fréquemment utilisés dans les années soixante pour amplifier des signaux et les décaler en fréquence. Tant que ces amplificateurs paramétriques ne sont pas basés sur des semi-conducteurs à effet de champ et des résistances, ils ne souffrent pas des bruits de Johnson, Shot et 1/f, résultant dans des amplificateurs à bas bruit.

Cet article présente un amplificateur à effet paramétrique micromécanique à décalage en fréquence supérieure. Ce type de dispositif peut être notamment utilisé pour construire des dispositifs de détection de signaux basses fréquences. L'élément non-linéaire est un condensateur micromécanique à valeur de capacité variable en fonction du temps. La valeur de capacité du condensateur variable détermine l'impédance d'entrée et de sortie de l'amplificateur paramétrique.

La caractéristique intéressante de ces amplificateurs paramétriques est l'absence théorique de perte - ou tout du moins négligeable - au travers du condensateur non-linéaire. Ainsi, la puissance stockée dans la capacité à la fréquence de pompage correspond à la puissance délivrée par la capacité aux autres fréquences au travers de l'interaction non-linéaire du condensateur avec le reste du dispositif de détection.

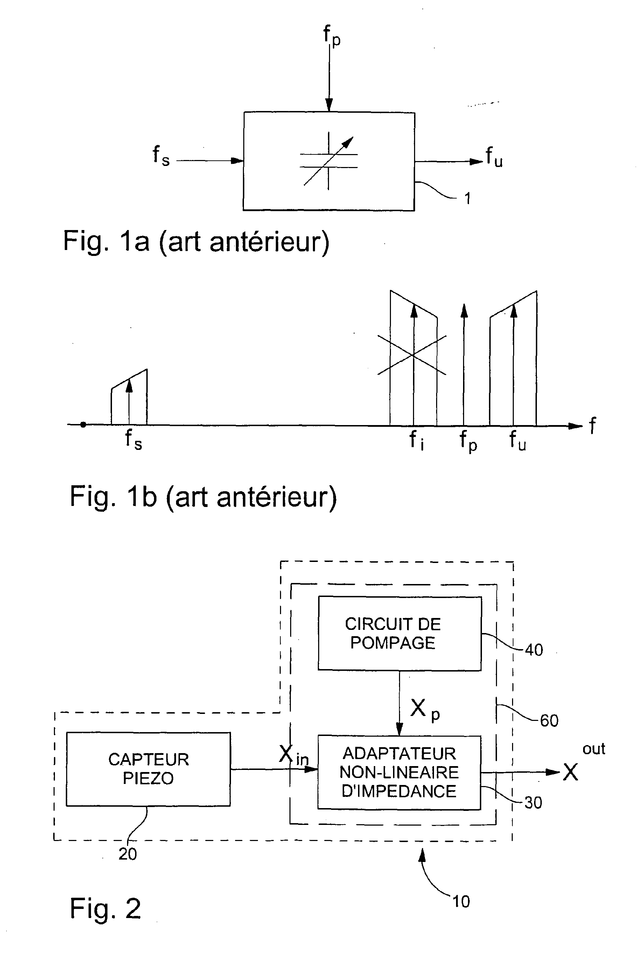

Le principe de fonctionnement décrit dans cet article va être explicité en rapport avec les figures 1 a et 1 b. La figure 1 a représente le modèle équivalent d'un amplificateur à effet paramétrique 1 qui reçoit, d'une part, des signaux externes basse fréquence fs, d'autre part, des signaux de pompage à la fréquence de pompage fp, et délivre en sortie un signal amplifié à une fréquence fu correspondant à la somme des fréquences fs et fp. La figure 1 b représente le spectre des amplitudes relatif au circuit de la figure 1 a. On retrouve le signal basse fréquence fs, qui est un signal avec une faible amplitude, le signal de pompage à la fréquence de pompage fp, ainsi que le signal de sortie à la fréquence de sortie fu (fp+fs) et à la fréquence image fi (fp-fs). Dans l'exemple représenté, on comprendra que les signaux à la fréquence image fi sont filtrés.

Suivant les besoins, la fréquence du signal de pompage fp peut être augmentée, lorsque la taille de la membrane du condensateur micromécanique est réduite. Pour diminuer l'amplitude du signal de pompage, la structure mécanique du condensateur est réalisée avec une fréquence de résonance correspondant à la fréquence de pompage fp. De plus, pour obtenir un bon coefficient d'amplification, on détermine les variations de la valeur de capacité du condensateur de l'amplificateur.

Toutefois, l'amplificateur à effet paramétrique 1 proposé dans cet article présente quelques inconvénients. En effet, l'utilisation d'un condensateur micromécanique à capacité variable nécessite d'une part un procédé de fabrication relativement complexe en vue d'assurer un bon ajustement de la plage de valeurs utilisable pour faire varier la capacité. De plus, pour détecter des petits signaux très basses fréquences, c'est-à-dire de l'ordre du Hertz, la solution mécanique proposée dans cet article présente un rapport signal sur bruit défavorable comme les solutions traditionnelles utilisant des composants linéaires pour adapter l'impédance.

RÉSUMÉ DE L'INVENTION

L'un des buts de la présente invention est de pouvoir détecter tout type de signaux externes, et en particulier les petits signaux basses fréquences au moyen d'un dispositif de détection permettant d'amplifier et décaler en fréquence les signaux externes reçus. Pour cela, il est prévu d'adapter l'impédance des signaux reçus, selon une méthode similaire à celle proposée dans l'article susmentionné, c'est-à-dire au moyen d'un amplificateur paramétrique à décalage en fréquence supérieure comprenant un composant électrique non-linéaire permettant d'obtenir un bon transfert de puissance sans nécessité l'utilisation de composants électriques linéaires ayant des valeurs extrêmes. Ainsi comme l'adaptation d'impédance est basé sur une transformation fréquentielle, le signal à mesurer est décalé dans des gammes de fréquences plus élevées pour lesquelles le bruit des composants électriques, en particulier du type semi-conducteur, est nettement moins critique.

Le dispositif de détection selon un mode de réalisation préféré de l'invention se distingue, d'une part, par le type de composant non-linéaire employé pour assurer l'adaptation d'impédance et, d'autre part, par le principe de fonctionnement utilisé, qui est basé sur l'idée de stimuler le dispositif de détection par l'intermédiaire de la valeur du composant non-linéaire à la fréquence de résonance du capteur, cette fréquence de résonance du capteur pouvant être éventuellement ajustée en ajoutant des composants additionnels au dispositif.

L'un des principaux avantages à utiliser, comme fréquence de pompage, la fréquence de résonance du capteur est de pouvoir assurer une amplification maximale des signaux reçus quelle que soit leur fréquence et obtenir un signal oscillant à la fréquence de résonance du capteur avec une amplitude proportionnelle à celle du signal basse fréquence causé par l'accélération mesurée. Pour mettre en oeuvre cette stimulation, le composant non-linéaire est commandé par un circuit de pompage permettant en particulier de déterminer la fréquence de résonance du capteur. Selon une variante préférée, le composant non-linéaire utilisé est en particulier, un condensateur ayant une valeur de capacité contrôlée par un signal électrique permettant de modifier cette valeur sans changer la charge du condensateur durant le réglage de la nouvelle valeur de capacité. D'autres composants électriques non-linéaires peuvent être également utilisés, comme par exemple, un composant non-linéaire du type memristor.

La présente invention a ainsi pour objet un dispositif de détection de signaux électriques du type susmentionné dont les caractéristiques sont énoncées dans la revendication 1.

Des modes de réalisation avantageux de la présente invention font l'objet des revendications dépendantes.

L'invention concerne également le procédé de mise en oeuvre d'un tel dispositif de détection.

BRÈVE DESCRIPTION DES DESSINS

D'autres caractéristiques et avantages de la présente invention apparaîtront plus clairement à la lecture de la description détaillée qui suit de modes de réalisation de l'invention donnés uniquement à titre d'exemple non limitatif et illustrés par les dessins annexés où :

- La figure 1a représente un modèle équivalent d'un amplificateur à effet paramétrique selon l'art antérieur ;
- la figure 1b représente le spectre des amplitudes du modèle d'amplificateur de la figure 1 a ;
- la figure 2 représente un schéma bloc d'un dispositif de détection selon un premier mode de réalisation de l'invention ;
- la figure 3a représente un schéma équivalent du capteur du dispositif de détection de la figure 2 ;
- la figure 3b représente la fonction de transfert du modèle équivalent du capteur de la figure 3a ;
- la figure 4a représente un circuit d'adaptation de l'impédance selon une variante de réalisation préférée de l'invention ;
- la figure 4b représente un exemple de circuit de pompage du dispositif de détection de la figure 2 ;
- la figure 5 représente les variations de valeurs du composant électrique non-linéaire en fonction du signal détecté ;
- la figure 6 représente un dispositif de détection selon un deuxième mode de réalisation de l'invention dans lequel le circuit d'adaptation d'impédance comprend un memristor comme composant électrique non-linéaire;
- la figure 7 représente un exemple de réalisation d'un condensateur non-linéaire.

DESCRIPTION DE MODES DE RÉALISATION PRÉFÉRÉS

L'invention procède, comme déjà mentionné, de l'idée générale qui consiste à détecter des signaux externes, en particulier des signaux basses fréquences et haute impédance. Selon l'utilisation particulière de l'invention à un accéléromètre, le dispositif de détection d'accélération comprend un capteur piézo-électrique ou piézo-céramique pouvant osciller à des fréquences nettement supérieures à la bande de fréquences des accélérations mesurées.

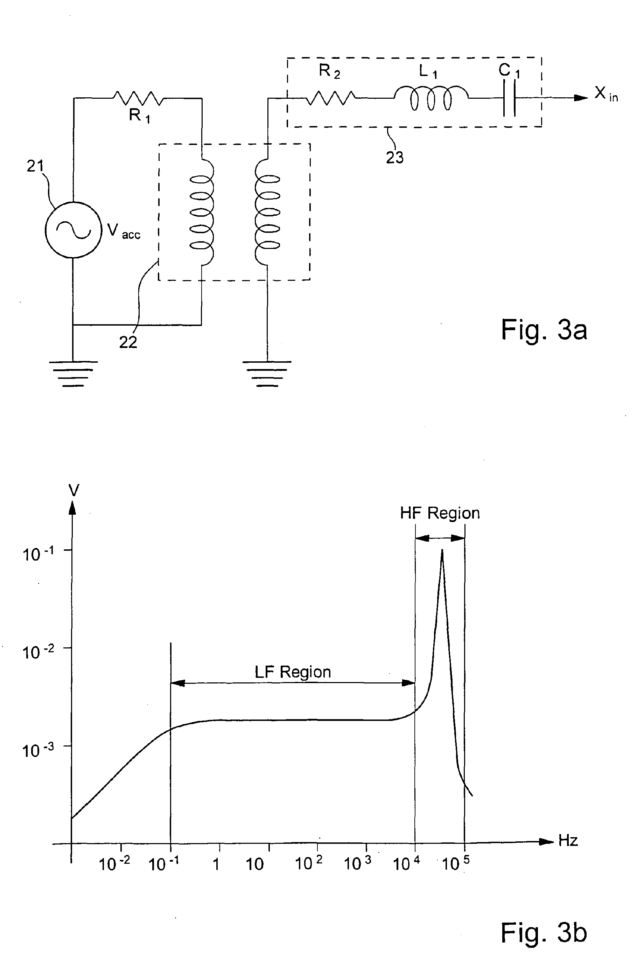

La figure 2 représente un schéma bloc du dispositif de détection selon un premier mode préféré de réalisation de l'invention. Le dispositif de détection 10 comprend un capteur de signaux externes 20. Dans l'utilisation particulière du dispositif de détection comme accéléromètre, on utilisera par exemple un capteur piézoélectrique permettant de détecter des chocs. Ce capteur 20 peut être assimilé à un circuit résonant mécanique, dont le détail sera donné à la figure 3a, ayant une fréquence de résonance Fc. Ce capteur 20 délivre des signaux Xin représentatifs des signaux externes reçus, à un amplificateur paramétrique 60 comprenant un circuit d'adaptation d'impédance 30 non-linéaire permettant d'amplifier les signaux Xin reçus, d'une part, et de les décaler en fréquence d'autre part. Ce circuit d'adaptation d'impédance 30 comprend au moins un élément non-linéaire évitant l'utilisation de composants électriques discrets ayant des valeurs trop importantes. L'amplificateur paramétrique 60 comprend également un circuit de pompage 40 pour contrôler le circuit d'adaptation d'impédance 30, en envoyant un signal Xp qui commande les variations de valeurs du composant électrique non-linéaire du circuit d'adaptation d'impédance 30. Le circuit de pompage 40 est agencé de manière à faire varier cette valeur à la fréquence de résonance Fc du capteur 20. Le signal Xout récupéré en sortie du circuit de détection correspond ainsi au signal externe détecté, amplifié et décalé à une fréquence supérieure par l'amplificateur paramétrique 60.

La figure 3a représente un modèle équivalent simplifié du capteur du dispositif de détection de la figure 2. Le capteur 20 est modélisé par une source de tension 21 ayant une résistance interne R1 et générant un signal Vacc qui est l'image de l'accélération, la source de tension étant connecté à un transformateur de liaison 22, qui représente le convertisseur d'énergie mécanique en énergie électrique du capteur. Le transformateur 22 est connecté d'autre part à un circuit résonant 23, de type RLC, qui représente l'élément résonant du capteur ayant une fréquence de résonance Fc. Le transformateur de liaison 22 et le circuit résonant 23 introduisent chacun un important rapport de division de tension, par exemple de l'ordre de 25. Le modèle équivalent du capteur présente, pour un signal d'accélération sinusoïdale, une fonction de transfert, illustrée à la figure 3b, sur laquelle on distingue une première région basse fréquence (LF Region), par exemple entre 10mHz et 10KHz, dans laquelle la tension est environ 625 fois plus petite que celle délivrée par la source de tension et une deuxième région haute fréquence (HF Region) dans laquelle la tension de sortie est amplifiée par le haut facteur de qualité du circuit résonant mécanique 23 $R_2L_1C_1$ équivalent.

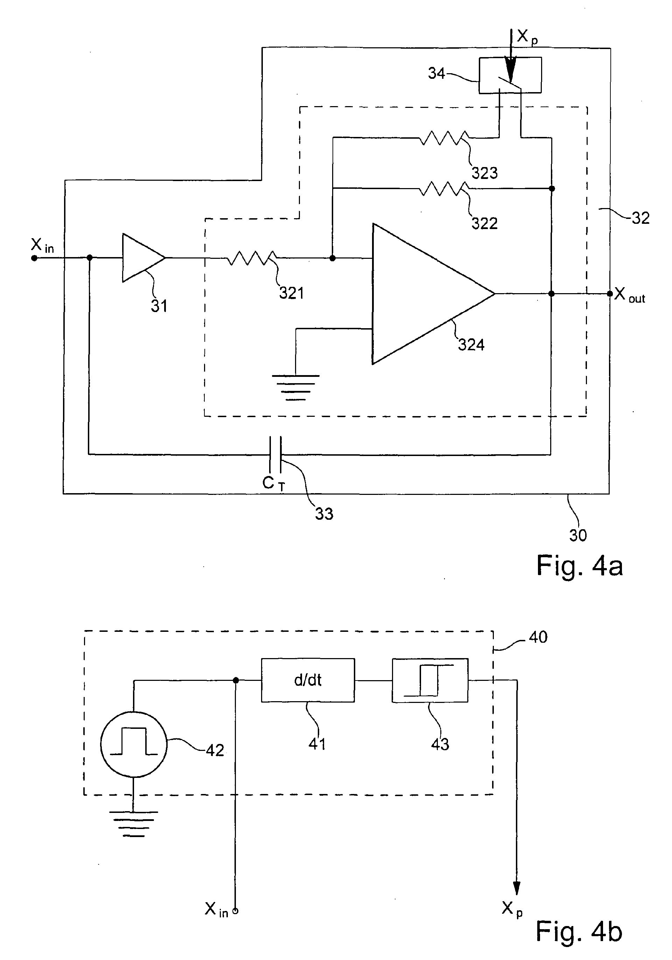

Dans le cadre de la présente invention, il a été mis en évidence la nécessité d'utiliser un amplificateur paramétrique comprenant un circuit d'adaptation d'impédance ayant des caractéristiques non-linéaires, représenté à la figure 4a, et un circuit à pompe de charges, représenté à la figure 4b.

Ainsi, la figure 4a représente le circuit d'adaptation d'impédance d'un tel amplificateur paramétrique selon une première variante préférée de réalisation. L'adaptation d'impédance est réalisée au moyen d'un circuit d'adaptation d'impédance 30 qui comprend en entrée un amplificateur 31 connecté à un circuit amplificateur inverseur 32 et un composant électrique non-linéaire connecté entre l'entrée de l'amplificateur d'entrée 31 et la sortie de l'amplificateur inverseur 32. Le composant non-linéaire est réalisé, dans cet exemple, au moyen d'un condensateur 33 à valeur de capacité Ct variable non linéairement dans le temps.

L'amplificateur inverseur 32 est constitué par les résistances 321, 322 et 323 et l'amplificateur opérationnel 324. Un interrupteur 34 commandé par le signal Xp délivré par le circuit de pompage (non représenté ici) est disposé entre la résistance 323 et la sortie de l'amplificateur opérationnel 324. Cet interrupteur 34 est alternativement ouvert puis fermé à la fréquence du signal de pompage Xp. Il en résulte que la tension Xout délivrée en sortie du circuit amplificateur inverseur 32 varie entre deux valeurs suivant que la résistance 323 est connectée ou non. La fréquence du signal de pompage est choisie sensiblement égale à la fréquence de résonance du capteur. Il est important de noter que le processus de commutation de l'interrupteur 34 étant nettement plus rapide que le temps de réponse de l'amplificateur paramétrique 30 et, en particulier, du condensateur 33 dont la charge ne varie pas - ou varie de manière négligeable - pendant la commutation de l'interrupteur 34.

C'est pourquoi, la charge aux bornes du condensateur 33 peut être considérée comme ne variant pas lors de la commutation d'une position à l'autre de l'interrupteur 34. Ainsi, d'après la relation

$$C = Q.U$$

avec C représentant la valeur de capacité du condensateur, Q la charge accumulée entre ses deux bornes et U la tension entre ces deux mêmes bornes, si la charge Q du condensateur ne varie pas, alors que la tension U à ses bornes est modifiée, alors la valeur de capacité est modifiée en conséquence.

Selon la première variante représentée à la figure 4a, le circuit amplificateur inverseur 32 commandé par l'intermédiaire du signal Xp, permet de changer alternativement la valeur de capacité du condensateur 33 entre les deux valeurs de capacité déterminées, en particulier, par les résistances 322 et 323. On notera qu'à titre de variante, il est possible d'utiliser un circuit amplificateur inverseur 32 présentant plusieurs autres résistances disposées en parallèle les unes des autres, de manière à pouvoir modifier sélectivement la valeur de capacité du condensateur 33 entre trois valeurs ou plus. Selon encore une autre variante, il est possible de faire varier progressivement la valeur de capacité du condensateur à l'intérieur d'une plage déterminée de valeurs en utilisant par exemple une résistance variable dont la valeur de résistance est commandé par le circuit de pompage.

La figure 4b représente un exemple de circuit de pompage de l'amplificateur paramétrique représenté à la figure 2. Le circuit de pompage 40 est connecté en parallèle du condensateur non-linéaire Ct, soit entre les bornes d'entrée et de sortie du circuit d'adaptation d'impédance 30. Selon l'exemple illustré, le circuit de pompage comprend un circuit dérivateur 41 fournissant en sortie un signal de pompage Xp commandant les variations de valeurs de la capacité du condensateur 33. De préférence, un comparateur 43 est placé en sortie du circuit dérivateur 41 pour déterminer le signe du signal de pompage Xp. Ainsi, afin de commuter la valeur du composant électrique non-linéaire à la fréquence de résonance du capteur, le circuit de pompage comprend un circuit dérivateur 41 qui dérive le signal aux bornes du composant électrique non-linéaire, et un comparateur 43 qui permet de détecter les points d'inflexion correspondant à une tension / énergie stockée minimum ou maximum aux bornes du composant électrique non-linéaire. Ainsi pour chaque extremum détecté, les moyens de commutation sont activés et la valeur du composant est modifiée.

Le signal de pompage Xp, comme cela a déjà été mentionné précédemment, est un signal à la fréquence de résonance du capteur 20. Pour obtenir un tel signal de pompage, il est avantageusement prévu un circuit de démarrage 42 permettant d'initialiser les oscillations du circuit de pompage à la fréquence de résonance Fc. Pour cela, le circuit de démarrage peut comprendre par exemple une source de courant délivrant une impulsion de courant d'une charge prédéterminée. Une fois la phase d'initialisation effectuée, le circuit de pompage permet de faire varier la valeur de la capacité en mesurant le signal aux bornes de la capacité et ajustant sa valeur dès que l'état de la mesure du signal requiert un changement de valeur.

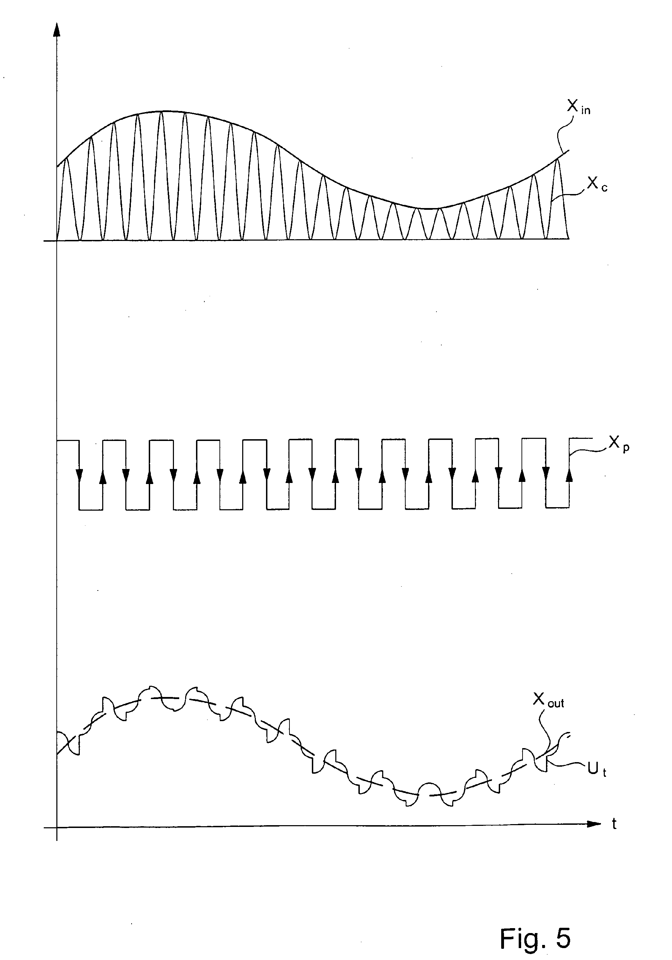

La figure 5 représente, de manière générale, les variations de valeurs du composant électrique non-linéaire en fonction du signal détecté, et plus particulièrement, les variations de la valeur de capacité du circuit d'adaptation d'impédance présenté à la figure 4a. On notera que sur cette figure 5, la phase d'initialisation pendant laquelle le circuit de pompage mesure la fréquence de résonance du capteur n'est pas représentée. Le signal Xin représente le signal mesuré par le capteur, le signal Xc représente le signal d'oscillation propre du capteur à sa fréquence de résonance Fc. Le signal de pompage Xp commande alternativement l'ouverture et la fermeture de l'interrupteur à la fréquence de résonance Fc du capteur. Le signal Ut représente les variations de la tension aux bornes du condensateur non-linéaire Ct. En effet, entre deux fronts du signal de commande Xp, la valeur de capacité est constante, ainsi, la tension aux bornes du condensateur croit et décroît lorsque le condensateur, respectivement, se charge et se décharge. En revanche, lors d'un front montant ou descendant, la valeur de la capacité est respectivement augmentée ou diminuée sans variation de la charge aux bornes du condensateur et donc la tension aux bornes du condensateur est respectivement diminuée ou augmentée de manière non-linéaire. Le signal Ut correspond au signal d'entrée Xin amplifié et décalé à une fréquence supérieure pour laquelle le rapport signal sur bruit est plus important. Le signal Xout représente le signal moyen en sortie du circuit amplificateur 30. Ce signal Xout correspond, avec une amplitude proportionnelle, au signal d'entrée Xin, c'est-à-dire au signal basse fréquence causé par l'accélération mesurée par le capteur.

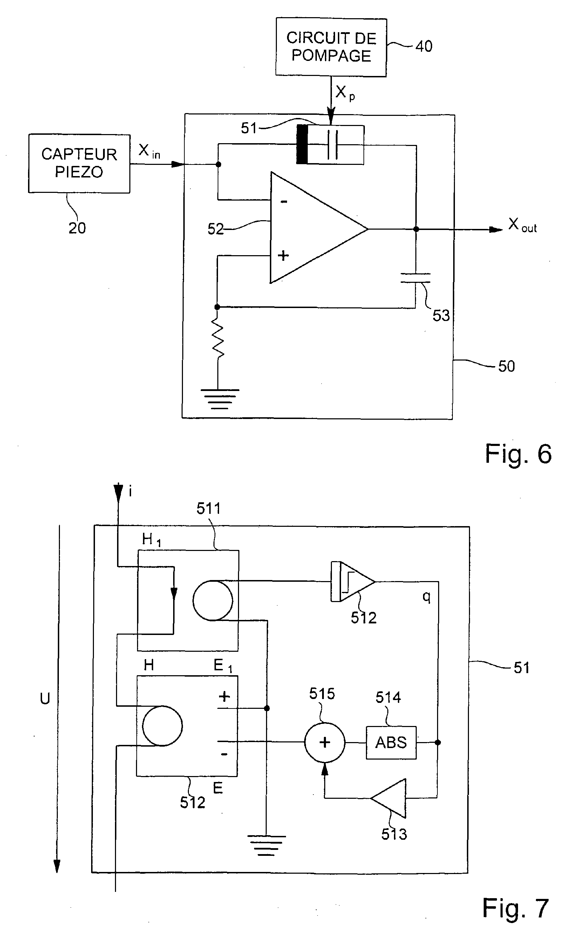

Selon un deuxième mode de réalisation de l'invention représenté à la figure 6, le circuit d'adaptation d'impédance comprend comme composant électrique non-linéaire un memristor ayant une valeur de memristance variable non-linéairement dans le temps. Le memristor est défini au moyen de la relation existante entre le flux et la charge. La valeur d'une memristance est donnée par la formule suivante :

$$M(q) = \frac{d\varphi(q)}{dq}$$

L'unité de valeur d'une memristance est la même que celle d'une résistance. La différence vient de ce que la valeur de memristance varie non-linéairement au cours du.temps et que cette valeur dépend des précédentes valeurs de tension et de courant aux bornes du memristor.

Le dispositif de détection comprend un capteur 20 permettant de mesurer des signaux externes, le capteur 20 étant connecté à un amplificateur paramétrique comprenant un memristor 50 utilisé comme circuit non-linéaire d'adaptation d'impédance commandé par un circuit de pompage 40. Un tel memristor 50 peut être modélisé au moyen d'un condensateur non-linéaire 51 connecté entre la borne d'entrée négative et la borne de sortie d'un amplificateur opérationnel 52, et d'un condensateur 53 classique connecté entre la borne d'entrée positive et la borne de sortie de l'amplificateur opérationnel 52. Le circuit de pompage envoie un signal de commande Xp au condensateur non-linéaire permettant de faire varier sa valeur de capacité à la fréquence de résonance du capteur 20.

La figure 7 représente un exemple de réalisation d'un tel condensateur non-linéaire 51. Ce condensateur comprend une source de courant 511 contrôlée par le courant traversant le condensateur non-linéaire. Cette source de courant est utilisé comme miroir de courant, dont la sortie est connectée à un intégrateur 512 ayant pour rôle de transformer le courant reçu en une tension. Cette tension est ensuite fournie, d'une part, à un circuit amplificateur 513 et, d'autre part, à un circuit 514 permettant d'obtenir la valeur absolue d'un signal. Les signaux délivrés par ces deux circuits 513 et 514 sont ensuite additionnés au travers d'un additionneur 515 délivrant une tension pour contrôler une source de tension 516 recevant en entrée le courant miré par la source de courant 511.

L'invention concerne également le procédé de mise en oeuvre d'un dispositif de détection selon l'un quelconque des modes de réalisations sus-présentés, pour la détection des signaux externes.

De préférence, il est prévu dans un premier temps une étape préliminaire permettant d'initialiser le circuit de pompage afin de faire varier non-linéairement la valeur du composant électrique du circuit d'adaptation d'impédance à la fréquence de résonance du capteur. Cette étape préliminaire consiste à charger le composant électrique non-linéaire avec une brève impulsion de courant équivalent à une charge prédéterminée.

Le procédé de détection de signaux externes proprement dit comprend les étapes suivantes :

- mesure des signaux externes par le capteur ;
- adaptation de l'impédance des signaux externes reçus par le capteur ;

l'étape d'adaptation étant décomposée en deux sous-étapes consistant à :

- amplifier les signaux externes reçus ;
- décaler à une fréquence supérieure les signaux reçus en faisant varier non-linéairement dans le temps la valeur du composant électrique du circuit d'adaptation ;

le procédé étant caractérisé en ce que l'étape d'adaptation d'impédance est réalisée en faisant varier la valeur du composant électrique à la fréquence de résonance du capteur.

Afin de commuter la valeur du composant électrique non-linéaire à la fréquence de résonance du capteur, le circuit de pompage comprend un circuit différentiateur qui dérive le signal aux bornes du composant électrique non-linéaire et un comparateur qui permet de détecter les points d'inflexion correspondant à une tension / énergie stockée minimum ou maximum aux bornes du composant électrique non-linéaire. Ainsi pour chaque extremum détecté, les moyens de commutation sont activés et la valeur du composant est modifiée.

Selon une variante du procédé, il est prévu de comparer le niveau de tension des signaux externes reçus par le capteur avec un niveau de tension prédéterminé correspondant à un bruit moyen, et si le niveau de tension du signal reçu est inférieur à celui du premier niveau prédéterminé, il est alors prévu d'ajouter une tension d'offset au signal reçu.

Selon une autre variante du procédé, il est prévu de comparer le niveau de tension des signaux externes reçus par le capteur avec un niveau de tension correspondant à une tension d'offset prédéterminée, et si le niveau de tension du signal reçu n'est pas égal audit niveau de tension plus ou moins un niveau de bruit moyen, il est alors prévu d'ajouter la tension d'offset prédéterminée au signal reçu.

On comprendra que diverses modifications et / ou améliorations évidentes pour l'homme du métier peuvent être apportées aux différentes modes de réalisation de l'invention décrits dans la présente description sans sortir du cadre de l'invention défini par les revendications annexées.

On a principalement décrit l'invention pour un dispositif de détection d'accélération, mais il est également envisageable d'utiliser ce dispositif pour détecter d'autres types de signaux basses fréquences, il est également possible d'utiliser ce dispositif comme antenne.

## Revendications

1. Dispositif de détection (10) comprenant un capteur (20) pour mesurer un signal externe, ledit capteur ayant une fréquence de résonance (Fc), un circuit d'adaptation d'impédance non-linéaire (30 ; 50 ; 60) pour amplifier le signal mesuré (Xin) et le décaler à une fréquence supérieure, ledit circuit d'adaptation d'impédance comprenant au moins un composant électrique (33 ; 51 ; 61, 62) ayant une valeur variable non-linéairement dans le temps et un circuit de pompage (40) du circuit d'adaptation d'impédance pour faire varier la valeur dudit composant électrique, **caractérisé en ce que** ledit circuit de pompage délivre des signaux (Xp) pour faire varier non-linéairement la valeur du composant à ladite fréquence de résonance du capteur.

2. Dispositif de détection selon la revendication 1, **caractérisé en ce que** le composant électrique non-linéaire (33) est un condensateur à capacité variable, tel que la charge du condensateur ne varie pas durant les changements de valeurs de capacité.

3. Dispositif de détection selon la revendication 2, **caractérisé en ce que** la valeur de capacité du condensateur (33) est sélectionnée entre au moins deux valeurs de capacité déterminées et **en ce que** le circuit d'adaptation d'impédance comprend en outre un circuit amplificateur inverseur (32) pour déterminer lesdites au moins deux valeurs de capacité déterminées.

4. Dispositif de détection selon la revendication 2, **caractérisé en ce que** la valeur de capacité du condensateur (33) est progressivement ajustée et **en ce que** le circuit d'adaptation d'impédance comprend en outre un circuit amplificateur inverseur pour contrôler la valeur de capacité.

5. Dispositif de détection selon la revendication 1, **caractérisé en ce que** le composant électrique non-linéaire est formé par un memristor (50) à memristance variable commander par le circuit de pompage.

**6.** Dispositif de détection selon l'une quelconque des revendications précédentes, **caractérisé en ce que** le circuit de pompage comprend un circuit dérivateur (41) pour faire varier la valeur du composant non-linéaire à la fréquence de résonance du capteur.

**7.** Dispositif de détection selon la revendication 6, **caractérisé en ce que** le circuit de pompage comprend en outre un circuit de démarrage (42) pour déterminer la fréquence de résonance propre du circuit de détection.

**8.** Dispositif de détection selon la revendication 7, **caractérisé en ce que** le circuit de démarrage comprend un générateur d'impulsion de courant de charge.

**9.** Dispositif de détection selon l'une quelconque des revendications précédentes, **caractérisé en ce que** le capteur est un capteur piézoélectrique ou piézocéramique d'accélération et/ou de chocs.

**10.** Procédé de mise en oeuvre d'un dispositif de détection de signaux externes selon l'une quelconque des revendications précédentes, pour la détection desdits signaux externes comprenant les étapes suivantes :

- mesurer des signaux externes par le capteur ;
- adapter de l'impédance des signaux externes reçus par le capteur ;

l'étape d'adaptation étant décomposée en deux sous-étapes consistant à :

- amplifier les signaux externes reçus ;
- décaler à une fréquence supérieure les signaux reçus en faisant varier non-linéairement dans le temps la valeur du composant électrique du circuit d'adaptation ;

le procédé étant **caractérisé en ce que** l'étape d'adaptation d'impédance est réalisée en faisant varier la valeur du composant électrique à la fréquence de résonance du capteur.

**11.** Procédé de détection de signaux externes selon la revendication 10, **caractérisé en ce qu'**il comprend une étape préliminaire consistant à :

- charger le composant électrique non-linéaire avec une brève impulsion de courant équivalent à une charge prédéterminée.

**12.** Procédé de détection de signaux externes selon la revendication 10 ou 11, **caractérisé en ce qu'**il est prévu de :

- comparer le niveau de tension des signaux externes reçus par le capteur avec un niveau de tension prédéterminé correspondant à un bruit moyen ; et
- d'ajouter une tension d'offset au signal reçu, si le niveau de tension du signal reçu est inférieur à celui du premier niveau prédéterminé.

**13.** Procédé de détection de signaux externes selon la revendication 10 ou 11, **caractérisé en ce qu'**il est prévu de :

- comparer le niveau de tension des signaux externes reçus par le capteur avec un niveau de tension correspondant à une tension d'offset prédéterminée ;
- d'ajouter la tension d'offset prédéterminée au signal reçu, si le niveau de tension du signal reçu n'est pas égal audit niveau de tension plus ou moins un niveau de bruit moyen.

$f_p$

$f_s \longrightarrow$ $\longrightarrow f_u$

1

Fig. 1a (art antérieur)

$f$

$f_s$ $f_i$ $f_p$ $f_u$

Fig. 1b (art antérieur)

CIRCUIT DE POMPAGE

40

$X_p$

60

CAPTEUR PIEZO

$X_{in}$

ADAPTATEUR NON-LINEAIRE D'IMPEDANCE

$X^{out}$

30

20

10

Fig. 2

Fig. 3a

Fig. 3b

Fig. 4a

Fig. 4b

$X_{in}$

$X_c$

$X_p$

$X_{out}$

$U_t$

t

Fig. 5

Fig. 6

Fig. 7

**Office européen des brevets**

# RAPPORT DE RECHERCHE EUROPEENNE

Numéro de la demande

EP 04 00 0260

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| D,Y | RASKIN J-P ET AL: "A NOVEL PARAMETRIC-EFFECT MEMS AMPLIFIER" JOURNAL OF MICROELECTROMECHANICAL SYSTEMS, IEEE INC. NEW YORK, US, vol. 9, no. 4, 1 décembre 2000 (2000-12-01), pages 528-537, XP001011616 ISSN: 1057-7157 * page 528, colonne de droite, ligne 36 - page 530, colonne de droite, ligne 22; figure 2 * ----- | 1-13 | H03F7/00 H03F7/04 G01P15/09 G01P15/08 |
| Y | HAO LUO ET AL: "A 1 mG lateral CMOS-MEMS accelerometer" MEMS2000 INTERNATIONAL CONFERENCE, 23 janvier 2000 (2000-01-23), pages 502-507, XP010377178 * page 502, colonne de droite, ligne 4 - page 504, colonne de droite, ligne 9; figures 2,3,5-7 * ----- | 1-13 | |
| A | JIANGFENG WU ET AL: "A low-noise low-offset chopper-stabilized capacitive-readout amplifier for CMOS MEMS accelerometers" SOLID STATE CIRCUITS CONFERENCE 2002, vol. 2, 3 février 2002 (2002-02-03), pages 348-541, XP010585098 * le document en entier * ----- | 1-13 | |

**DOMAINES TECHNIQUES RECHERCHES (Int.Cl.7)**

H03F
G01P

Le présent rapport a été établi pour toutes les revendications

| Lieu de la recherche | Date d'achèvement de la recherche | Examinateur |
|---|---|---|
| La Haye | 22 juin 2004 | Fedi, G |